(19)

Europäisches
Patentamt
European
Patent Office
Office européen
des brevets

(11)     EP 3 006 949 B1

## (12)     EUROPEAN PATENT SPECIFICATION

(45) Date of publication and mention
of the grant of the patent:
**19.04.2017 Bulletin 2017/16**

(51) Int Cl.:
**G01R 31/34** *(2006.01)*     **H02P 9/00** *(2006.01)*
**H02P 23/14** *(2006.01)*

(21) Application number: **14187738.1**

(22) Date of filing: **06.10.2014**

(54) **Method and arrangement for determining leakage inductances of double fed induction generator**

Verfahren und Anordnung zur Bestimmung von Streuinduktivitäten eines doppelt gespeisten Induktionsgenerators

Procédé et agencement pour déterminer les inductances de fuite d'un générateur asynchrone à alimentation double

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**13.04.2016 Bulletin 2016/15**

(73) Proprietor: **ABB Technology Oy
00380 Helsinki (FI)**

(72) Inventors:
• **Melin, Tomas
00380 Helsinki (FI)**
• **Virtanen, Reijo Kalevi
00380 Helsinki (FI)**

(74) Representative: **Kolster Oy Ab
Iso Roobertinkatu 23
PO Box 148
00121 Helsinki (FI)**

(56) References cited:
**WO-A2-2012/104580     US-A1- 2010 045 040
US-A1- 2011 102 012**

• **GRAHAM PANNELL ET AL: "Analytical Study of Grid-Fault Response of Wind Turbine Doubly Fed Induction Generator", IEEE TRANSACTIONS ON ENERGY CONVERSION, IEEE SERVICE CENTER, PISCATAWAY, NJ, US, vol. 25, no. 4, 1 December 2010 (2010-12-01), pages 1081-1091, XP011320529, ISSN: 0885-8969**
• **ALFEU J SGUAREZI FILHO ET AL: "Model-Based Predictive Control Applied to the Doubly-Fed Induction Generator Direct Power Control", IEEE TRANSACTIONS ON SUSTAINABLE ENERGY, IEEE, USA, vol. 3, no. 3, 1 July 2012 (2012-07-01), pages 398-406, XP011479414, ISSN: 1949-3029, DOI: 10.1109/TSTE.2012.2186834**

**Description**

FIELD OF THE INVENTION

The invention relates to determining leakage inductances of a double fed induction generator.

BACKGROUND OF THE INVENTION

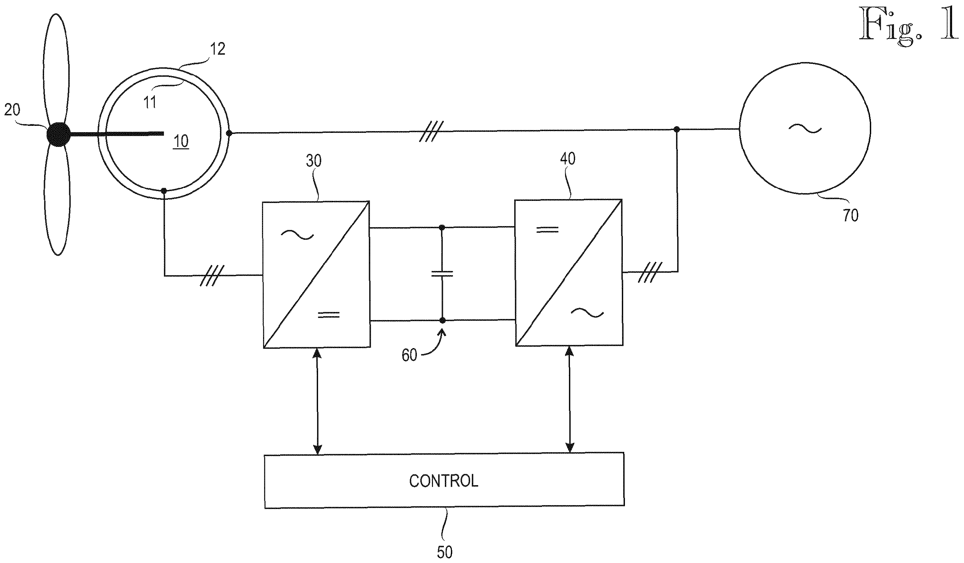

Wound rotor induction machines are electrical rotating machines in which the rotor comprises windings. One example of such machines is a double fed induction machine commonly used as a generator; a double fed induction generator (DFIG). Double fed induction generators may be used in a configuration as shown in the example of Figure 1 comprising converters such that one converter (inverter 30) is electrically connected between a direct voltage intermediate circuit 60 and a rotor 11 while another converter (rectifier 40) is electrically connected between the direct voltage intermediate circuit 60 and an alternating current network 70; typically the alternating current network 70 supplied by the generator 10 and connected to a stator 12 of the generator. Such double fed induction generators are commonly used in connection with wind turbines 20, for example.

Estimation errors in machine parameter values are a common source for errors in the control of electrical machines. As regards electrical machines used as generators, such as double fed induction generators, these estimation errors may lead to inaccurate control, resulting in output inaccuracy for reactive and active power, for example. Poor following of reference set point may be compensated for e.g. by using a higher level control loop that acts on measured and requested error values and compensates the reference according to the actual output. However, higher level controllers need to have slow dynamics in order not to interfere with higher dynamics controllers. During a LVRT (Low Voltage RideTrough) situation, the slower controllers will have a negative effect on the performance due to their natural slow dynamic behavior, which is inherent in them because they are not based on generator modelling.

For example, in case of double fed induction generators, leakage inductance values given by the machine manufacturer or, if not available, values estimated by the user of the machine have been used in the control of the generator. If these leakage inductance values for some reason do not accurately match the real values, these incorrect values may lead to poor control performance of the double fed induction generator.

WO2012104580 discloses a typical double fed induction generator.

BRIEF DESCRIPTION OF THE INVENTION

The object of the invention is thus to provide a method and an apparatus for implementing the method so as to solve or at least alleviate the above problem. The object of the invention is achieved with a method, an arrangement, an inverter, and a frequency converter that are characterized by what is stated in the independent claims. Preferred embodiments of the invention are described in the dependent claims.

The invention is based on the idea of obtaining estimates of the machine leakage inductances on the basis of measurements performed on the double fed induction generator while it is operating.

An advantage of the invention is that a better estimation of actual machine leakage inductances improves the control performance and reduces the need for slow dynamics higher level controllers thus improving both the operation during normal power generation and a response time during transients in the network. The invention enables identification of the leakage inductance values automatically so that user given generator data can be verified and tuned according to actual values. The invention is also cost-efficient and easy to implement even in existing devices.

BRIEF DESCRIPTION OF THE FIGURES

In the following, the invention will be described in more detail in connection with preferred embodiments with reference to the accompanying drawings, in which

Figure 1 illustrates a block diagram of a double fed induction generator system according to an embodiment;
Figure 2 illustrates an equivalent circuit of an asynchronous machine according to an embodiment;
Figure 3 illustrates a block diagram of a control arrangement according to an embodiment; and
Figure 4 illustrates a flow diagram of a determination of leakage inductances according to an embodiment.

DETAILED DESCRIPTION OF THE INVENTION

The application of the embodiments herein is not restricted to any specific double fed induction generator, DFIG, system, but it may be applied to various DFIG systems. In addition, the use of the invention is not restricted to any specific basic frequency or to any specific voltage level, for example.

Figure 1 illustrates a simplified block diagram of a double fed induction generator system according to an embodiment. The figure only shows components necessary for understanding the invention. The exemplary double fed induction generator system comprises a double fed induction generator 10 having a rotor 11 and a stator 12. In this example the DFIG 10 is a three-phase DFIG. The rotor 11 of the DFIG 10 may be mechanically connected to a turbine 20, such as a wind turbine, for example, for driving the generator 10. The stator 12 of the DFIG 10 may be electrically connected to a three-phase alternating current (AC) network 70 for supplying electricity generated in the DFIG to the AC network 70. The rotor 11 of the DFIG 10 may be electrically connected to an inverter 30 for controlling the DFIG with the inverter 30. The inverter in turn may be connected to a direct current (DC) source, such as a DC intermediate circuit 60 supplied by a rectifier 40. The rectifier may be connected to the AC network 70, as shown in the example. The inverter 30 and the rectifier 40 may be separate units or form a frequency converter together with the DC intermediate circuit 60, for example. Figure 1 further shows a control arrangement in the form of a control unit 50 which can be used to control the inverter 30 and the rectifier 40. It should be noted that there could be separate control units for the inverter 30 and the rectifier 40 and such one or more control units 50 can be part of the inverter 30 and/or the rectifier 40, for example. The control unit 50, or a corresponding control arrangement, can receive measured values of quantities needed in the various embodiments herein from the converters 30, 40 and/or by using separate measuring arrangements. For example, the control unit 50 may receive measured values of a stator voltage of the DFIG 10 (can be essentially equal to the voltage of the AC network 70), a rotor voltage of the DFIG 10 and a rotor current of the DFIG 10 from the converters 30, 40 and a value of a stator current of the DFIG 10 from a suitable measuring arrangement (not shown).

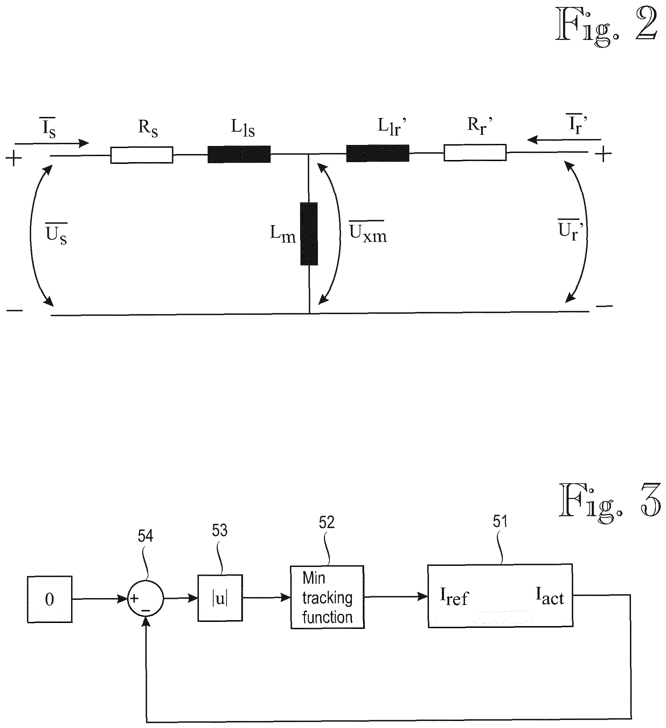

Figure 2 shows a T-model equivalent circuit for an asynchronous machine. When the machine is used as a DFIG, the rotor voltage can be controlled and the stator voltage is essentially the voltage of the AC network connected to the stator of the DFIG. In Figure 2 the following quantities are used:

$U_s$ = stator voltage of the DFIG
$I_s$ = stator current of the DFIG
$R_s$ = stator resistance of the DFIG
$L_{ls}$ = stator leakage inductance of the DFIG
$L_m$ = magnetizing inductance of the DFIG
$U_{xm}$ = voltage over the magnetizing inductance $L_m$
$U_r{}'$ = rotor voltage of the DFIG referred to the stator
$I_r{}'$ = rotor current of the DFIG referred to the stator
$R_r{}'$ = rotor resistance of the DFIG referred to the stator
$L_{lr}{}'$ = rotor leakage inductance of the DFIG referred to the stator,

where the rotor quantities of the DFIG referred to the stator equal to actual rotor side quantities as follows:

$U_r{}'$ = $N_{eff} U_r$ (where $U_r$ is the actual rotor voltage)
$I_r{}'$ = $1/N_{eff} I_r$ (where $I_r$ is the actual rotor current)
$R_r{}'$ = $N_{eff}{}^2 R_r$ (where $R_r$ is the actual rotor resistance)
$L_{lr}{}'$ $N_{eff}{}^2 L_{lr}$ (where $L_{lr}$ is the actual rotor inductance),

where

$N_{eff}$ = effective turns ratio of the DFIG.

In other words, quantities referred to the stator side merely represent another manner of representation of the quantities in question but are readily indicative of the actual quantities. In a similar manner, quantities of the stator side could be referred to the rotor side. In practice, rotor side quantities referred to the stator side are often readily available and used in practical applications.

Based on the equivalent circuit of Figure 2 and assuming that the stator current is zero, whereby the voltage $\overline{U_{xm}}$ over the magnetizing inductance equals the stator voltage $\overline{U_s}$, the following equation can be obtained:

$$L_{lr}{}' = \frac{\overline{U_r{}'} - \overline{U_s} - R_r{}' \overline{I_r{}'}}{\overline{I_r{}'}} \frac{1}{2\pi f} \qquad (1)$$

Thus, at a given frequency f, the rotor leakage inductance of the DFIG can be calculated on the basis of the stator voltage of the DFIG, the rotor voltage of the DFIG, the rotor current of the DFIG and the rotor resistance of the DFIG.

Moreover, considering that the rotor resistance may be negligible in comparison to the leakage inductance, or the value of the rotor resistance may be unknown, term $R_r'\overline{I_r}'$ can be assumed to be zero, whereby equation (1) can be simplified as:

$$L_{lr}' = \frac{\overline{U_r}' - \overline{U_s}}{\overline{I_r}'} \frac{1}{2\pi f} \tag{1a}$$

Thus, at a given frequency f, the rotor leakage inductance of the DFIG can be calculated on the basis of at least the stator voltage, the rotor voltage and the rotor current.

In a similar manner, based on the equivalent circuit of Figure 2 and assuming that the rotor current is zero, whereby the voltage $\overline{U_{xm}}$ over the magnetizing inductance equals the rotor voltage $\overline{U_r}'$ the following equation can be obtained:

$$L_{ls} = \frac{\overline{U_s} - \overline{U_r}' - R_s\overline{I_s}}{\overline{I_s}} \frac{1}{2\pi f} \tag{2}$$

Thus, at a given frequency f, the stator leakage inductance of the DFIG can be calculated on the basis of the stator voltage of the DFIG, the rotor voltage of the DFIG, the stator current of the DFIG and the stator resistance of the DFIG.

Moreover, considering that the stator resistance may be negligible in comparison to the leakage inductance, or the value of the stator resistance may be unknown, term $R_s\overline{I_s}$ can be assumed to be zero, whereby equation (2) can be simplified as:

$$L_{ls} = \frac{\overline{U_s} - \overline{U_r}'}{\overline{I_s}} \frac{1}{2\pi f} \tag{2a}$$

Thus, at a given frequency f, the stator leakage inductance of the DFIG can be calculated on the basis of at least the stator voltage, the rotor voltage and the stator current.

According to an embodiment, one or more leakage inductances of a double fed induction generator can be determined during operation of the DFIG by performing at least one of a) and b) as follows:

a) Controlling a rotor voltage of the DFIG such that a stator current of the DFIG approaches zero; in response to the stator current of the DFIG being equal or below a first predetermined threshold, determining values of a stator voltage of the DFIG, a rotor voltage of the DFIG and a rotor current of the DFIG, or quantities indicative thereof; and calculating a rotor leakage inductance of the DFIG on the basis of at least the determined values of the stator voltage of the DFIG, the rotor voltage of the DFIG and the rotor current of the DFIG, or the quantities indicative thereof. According to an embodiment, the rotor leakage inductance of the DFIG is calculated on the basis of the determined values of the stator voltage of the DFIG, the rotor voltage of the DFIG and the rotor current of the DFIG, or the quantities indicative thereof, and a rotor resistance of the DFIG or a quantity indicative thereof.

b) Controlling a rotor voltage of the DFIG such that the rotor current of the DFIG approaches zero; in response to the rotor current of the DFIG being equal or below a second predetermined threshold, determining values of the stator voltage of the DFIG, the rotor voltage of the DFIG and the stator current of the DFIG, or quantities indicative thereof; and calculating a stator leakage inductance of the DFIG on the basis of at least the determined values of the stator voltage of the DFIG, the rotor voltage of the DFIG and the stator current of the DFIG, or the quantities indicative thereof. According to an embodiment, the stator leakage inductance of the DFIG is calculated on the basis of the determined values of the stator voltage of the DFIG, the rotor voltage of the DFIG and the stator current of the DFIG, or the quantities indicative thereof, and a stator resistance of the DFIG or a quantity indicative thereof.

Thus, either one of the stator and rotor leakage inductances or both of them can be determined. According to an embodiment, the operation of the DFIG refers to a state where the DFIG 10 is in operation, i.e. connected to an AC network 70 and its stator side is synchronized with the AC network 70 connected to the stator 12 of the DFIG. However, during such operation of the DFIG the rotor speed is not necessarily at the synchronous speed but a slip may be present, i.e. the rotor speed may be below or above the synchronous speed. Preferably during the operation of the DFIG 10 the stator voltage of the DFIG 10 is within a nominal voltage range of the stator voltage of the DFIG whereby it can be assumed that the leakage inductances of the DFIG are not saturated. The DFIG main inductance saturation generally does not impact the result of the determination of the leakage inductances. It is further noted that the determination becomes more accurate when the slip of the DFIG is not too small. This is due to the fact that at an exact synchronous speed the rotor voltage is small because the rotor voltage is proportional to the slip. The amount of slip providing optimal determination results depends on the characteristics of the DFIG in question and thus no specific values for the slip are given here.

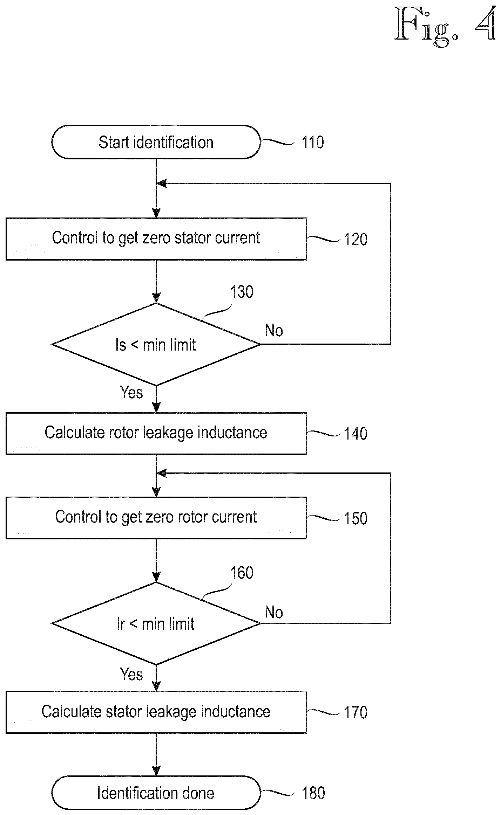

Figure 4 illustrates a flow diagram of a determination of the leakage inductances according to an embodiment. In step 110 the identification of the leakage inductances is started. The identification may be started by a request, which may originate from a user or operator of the system or from the system itself when needed, for example. In step 120, the rotor voltage of the DFIG is controlled with the inverter 30 such that the stator current of the DFIG approaches zero. In step 130 it is checked whether the stator current of the DFIG is equal to or below a first predetermined threshold. The first threshold is preferably a value close to zero or zero, depending on the characteristics of the system. Typically, the closer the threshold is to zero, the more accurate the determination result will be. If not, then step 120 is repeated. If yes, then in step 140 values of the stator voltage of the DFIG, the rotor voltage of the DFIG and the rotor current of the DFIG, or quantities indicative thereof are determined and the rotor leakage inductance of the DFIG is calculated on the basis of at least the determined values of the stator voltage of the DFIG, the rotor voltage of the DFIG and the rotor current of the DFIG, or the quantities indicative thereof. This may be done by utilizing equation (1) or (1a), for example. In step 150, the rotor voltage of the DFIG is controlled with the inverter 30 such that the rotor current of the DFIG approaches zero. In step 160 it is checked whether the rotor current of the DFIG is equal to or below a second predetermined threshold. The second threshold is preferably a value close to zero or zero depending on the characteristics of the system. Typically, the closer the threshold is to zero, the more accurate the determination result will be. If not, then step 150 is repeated. If yes, then in step 170 values of the stator voltage of the DFIG, the rotor voltage of the DFIG and the stator current of the DFIG, or quantities indicative thereof are determined and the stator leakage inductance of the DFIG is calculated on the basis of at least the determined values of the stator voltage of the DFIG, the rotor voltage of the DFIG and the stator current of the DFIG, or the quantities indicative thereof. This may be done by utilizing equation (2) or (2a), for example. In step 180 the identification of the leakage inductances is ended. The determined values of the leakage inductances are preferably stored in a suitable memory for later use. According to an embodiment, the determined rotor leakage inductance of the DFIG and/or the determined stator leakage inductance of the DFIG are used for controlling the DFIG. The values of the rotor leakage inductance of the DFIG and/or the determined stator leakage inductance of the DFIG may be updated periodically or as necessary. It should be noted that while in the example of Figure 4 the rotor leakage inductance of the DFIG is determined first, it is alternatively possible to determine the stator leakage inductance of the DFIG first. In this case steps 150 to 170 would be performed before steps 120 to 140. It is further possible to perform some steps, or parts of them, simultaneously.

Figure 3 illustrates a simplified block diagram of a control arrangement according to an embodiment. The exemplary control arrangement of Figure 3 can be used e.g. for steps 120 and/or 150 when controlling the stator or rotor current of the DFIG to approach zero. Reference for stator and rotor current are in turn internally set to zero (or a small value), for example, via member 54. A control system comprising an absolute value unit 53 and a minimum tracking function unit 52, for example, drives the current reference $I_{ref}$ of the DFIG controller part 51 such that a difference between the actual current $I_{act}$ and the reference goes towards a minimum utilizing the DFIG controller part 51. When the actual current $I_{act}$ is smaller than a predetermined threshold, identification results can be determined. The control arrangement comprising elements 51, 52, 53 and 54, or a similar arrangement, may be implemented inside the control arrangement 50.

An apparatus implementing the control functions according to any one of the embodiments herein, or a combination thereof, may be implemented as one unit or as two or more separate units that are configured to implement the functionality of the various embodiments. Here the term 'unit' refers generally to a physical or logical entity, such as a physical device or a part thereof or a software routine. One or more of these units, such as the control unit 50, may reside in an electric drive or a component thereof such as the inverter 30, for example.

An apparatus, such as the control unit 50, according to any one of the embodiments herein may be implemented at least partly by means of one or more computers or corresponding digital signal processing (DSP) equipment provided with suitable software, for example. Such a computer or digital signal processing equipment preferably comprises at least a working memory (RAM) providing storage area for arithmetical operations and a central processing unit (CPU), such as a general-purpose digital signal processor. The CPU may comprise a set of registers, an arithmetic logic unit, and a CPU control unit. The CPU control unit is controlled by a sequence of program instructions transferred to the CPU from the RAM. The CPU control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention, or a part thereof, may further comprise suitable input means for receiving e.g. measurement and/or control data, and output means for outputting e.g. control data. It is also possible to use a specific integrated circuit or circuits, or discrete electric components and devices for implementing the functionality according to any one of the embodiments.

The invention according to any one of the embodiments, or any combination thereof, can be implemented in existing system elements, such as electric drives or components thereof, such as inverters or frequency converters, or similar devices, or by using separate dedicated elements or devices in a centralized or distributed manner. Present devices for electric drives, such as inverters and frequency converters, typically comprise processors and memory that can be utilized in the functions according to embodiments of the invention. Thus, all modifications and configurations required for implementing an embodiment of the invention e.g. in existing devices may be performed as software routines, which may be implemented as added or updated software routines. If the functionality of the invention is implemented by software, such software can be provided as a computer program product comprising computer program code which, when run on a computer, causes the computer or corresponding arrangement to perform the functionality according to the invention as described above. Such a computer program code may be stored or generally embodied on a computer readable medium, such as suitable memory, e.g. a flash memory or a disc memory from which it is loadable to the unit or units executing the program code. In addition, such a computer program code implementing the invention may be loaded to the unit or units executing the computer program code via a suitable data network, for example, and it may replace or update a possibly existing program code.

It is obvious to a person skilled in the art that as technology advances, the basic idea of the invention can be implemented in a variety of ways. Consequently, the invention and its embodiments are not restricted to the above examples, but can vary within the scope of the claims.

**Claims**

1. A method for determining leakage inductances of a double fed induction generator, DFIG, the method comprising:

   during operation of the DFIG (10), performing at least one of a) and b):

   a) controlling (120) a rotor voltage of the DFIG such that a stator current of the DFIG approaches zero;
   in response to the stator current of the DFIG being (130) equal to or below a first predetermined threshold, determining (140) values of a stator voltage of the DFIG, a rotor voltage of the DFIG and a rotor current of the DFIG, or quantities indicative thereof; and
   calculating (140) a rotor leakage inductance of the DFIG on the basis of at least the determined values of the stator voltage of the DFIG, the rotor voltage of the DFIG and the rotor current of the DFIG, or the quantities indicative thereof,
   b) controlling (150) a rotor voltage of the DFIG such that the rotor current of the DFIG approaches zero;

   in response to the rotor current of the DFIG being (160) equal to or below a second predetermined threshold, determining (170) values of the stator voltage of the DFIG, the rotor voltage of the DFIG and the stator current of the DFIG, or quantities indicative thereof; and
   calculating (170) a stator leakage inductance of the DFIG on the basis of at least the determined values of the stator voltage of the DFIG, the rotor voltage of the DFIG and the stator current of the DFIG, or the quantities indicative thereof.

2. A method according to claim 1, wherein, as per alternative a), the rotor leakage inductance of the DFIG (10) is calculated (140) on the basis of the determined values of the stator voltage of the DFIG, the rotor voltage of the DFIG and the rotor current of the DFIG, or the quantities indicative thereof, and a rotor resistance of the DFIG, or a quantity indicative thereof.

3. A method according to claim 1 or 2, wherein, as per alternative b), the stator leakage inductance of the DFIG (10) is calculated (170) on the basis of the determined values of the stator voltage of the DFIG, the rotor voltage of the DFIG and the stator current of the DFIG, or the quantities indicative thereof, and a stator resistance of the DFIG, or a quantity indicative thereof.

4. A method according to claim 1, 2 or 3, wherein, during the operation of the DFIG (10), a stator (12) of the DFIG is synchronized with an AC network (70) connected to the stator (12) of the DFIG.

5. A method according to any one of claims 1 to 4, wherein, during the operation of the DFIG (10), the stator voltage of the DFIG (10) is within a nominal voltage range of the stator voltage of the DFIG.

6. A method according to any one of claims 1 to 4, wherein the rotor voltage of the DFIG is controlled with an inverter (30) connected to a rotor (11) of the DFIG.

7. A computer program product comprising computer program code, wherein execution of the program code in a computer causes the computer to carry out the steps of the method according to any one of claims 1 to 6.

8. An arrangement for determining leakage inductances of a double fed induction generator, DFIG, the arrangement comprising at least one of a) and b):

   a) means (30, 50) configured, during operation of the DFIG (10), to control a rotor voltage of the DFIG such that a stator current of the DFIG approaches zero;
   means (50) configured to, in response to the stator current of the DFIG being equal to or below a first predetermined threshold, determine values of a stator voltage of the DFIG, a rotor voltage of the DFIG and a rotor current of the DFIG, or quantities indicative thereof; and
   means (50) configured to calculate a rotor leakage inductance of the DFIG on the basis of at least the determined values of the stator voltage of the DFIG, the rotor voltage of the DFIG and the rotor current of the DFIG, or the quantities indicative thereof,
   b) means (30, 50) configured, during operation of the DFIG, to control a rotor voltage of the DFIG such that the rotor current of the DFIG approaches zero;

   means (50) configured to, in response to the rotor current of the DFIG being equal to or below a second predetermined threshold, determine values of the stator voltage of the DFIG, the rotor voltage of the DFIG and the stator current of the DFIG, or quantities indicative thereof; and
   means (50) configured to calculate a stator leakage inductance of the DFIG on the basis of at least the determined values of the stator voltage of the DFIG, the rotor voltage of the DFIG and the stator current of the DFIG, or the quantities indicative thereof.

9. An arrangement according to claim 8, wherein, as per alternative a), the means (50) configured to calculate are configured to calculate the rotor leakage inductance of the DFIG (10) on the basis of the determined values of the stator voltage of the DFIG, the rotor voltage of the DFIG and the rotor current of the DFIG, or the quantities indicative thereof, and a rotor resistance of the DFIG or a quantity indicative thereof.

10. An arrangement according to claim 8 or 9, wherein, as per alternative b), the means (50) configured to calculate are configured to calculate the stator leakage inductance of the DFIG (10) on the basis of the determined values of the stator voltage of the DFIG, the rotor voltage of the DFIG and the stator current of the DFIG, or the quantities indicative thereof, and a stator resistance of the DFIG or a quantity indicative thereof.

11. An arrangement according to claim 8, 9 or 10, wherein, during the operation of the DFIG (10), a stator (12) of the DFIG is synchronized with an AC network (70) connected to the stator (12) of the DFIG.

12. An arrangement according to any one of claims 8 to 11, wherein, during the operation of the DFIG, the stator voltage of the DFIG (10) is within a nominal voltage range of the stator voltage of the DFIG.

13. An inverter comprising an arrangement according to any one of claims 8 to 12.

14. An inverter according to claim 13, wherein the inverter (30) is configured to use the determined rotor leakage inductance of the DFIG and/or the determined stator leakage inductance of the DFIG for controlling the DFIG.

15. A frequency converter comprising an arrangement according to any one of claims 8 to 12.

**Patentansprüche**

1. Ein Verfahren zur Bestimmung von Streuinduktivitäten eines doppelt gespeisten Asynchrongenerators, DFIG, wobei das Verfahren umfasst:

   Ausführen von mindestens Einem von a) und b) während des Betriebs des DFIG (10):

   a) Steuern (120) einer Rotorspannung des DFIG, sodass ein Statorstrom des DFIG gegen Null geht; als Reaktion darauf, dass der Statorstrom des DFIG gleich oder kleiner als ein erster vorbestimmter Schwellwert ist (130), Ermitteln (140) von Werten einer Statorspannung des DFIG, einer Rotorspannung des DFIG und eines Rotorstroms des DFIG, oder Größen, die diese anzeigen; und
   Berechnen (140) einer Rotorstreuinduktivität des DFIG auf der Grundlage von zumindest den ermittelten Werten der Statorspannung des DFIG, der Rotorspannung des DFIG und des Rotorstroms des DFIG, oder den Größen, die diese anzeigen,
   b) Steuern (150) einer Rotorspannung des DFIG, sodass der Rotorstrom des DFIG gegen Null geht;

   als Reaktion darauf, dass der Rotorstrom des DFIG gleich oder kleiner als ein zweiter vorbestimmter Schwellwert ist (160), Ermitteln (170) von Werten der Statorspannung des DFIG, der Rotorspannung des DFIG und des Statorstroms des DFIG, oder Größen, die diese anzeigen; und
   Berechnen (170) einer Statorstreuinduktivität des DFIG auf der Grundlage von zumindest den ermittelten Werten der Statorspannung des DFIG, der Rotorspannung des DFIG und des Statorstroms des DFIG, oder den Größen, die diese anzeigen.

2. Ein Verfahren nach Anspruch 1, **dadurch gekennzeichnet, dass** für Alternative a) die Rotorstreuinduktivität des DFIG (10) auf der Grundlage der ermittelten Werte der Statorspannung des DFIG, der Rotorspannung des DFIG und des Rotorstroms des DFIG, oder den Größen, die diese anzeigen, und eines Rotorwiderstands des DFIG, oder einer Größe, die diesen anzeigt, berechnet wird (140).

3. Ein Verfahren nach Anspruch 1 oder 2, **dadurch gekennzeichnet, dass** für Alternative b) die Statorstreuinduktivität des DFIG (10) auf der Grundlage der ermittelten Werte der Statorspannung des DFIG, der Rotorspannung des DFIG und des Statorstroms des DFIG, oder den Größen, die diese anzeigen, und eines Statorwiderstands des DFIG, oder einer Größe, die diesen anzeigt, berechnet wird (170).

4. Ein Verfahren nach Anspruch 1, 2 oder 3, **dadurch gekennzeichnet, dass** während des Betriebs des DFIG (10) ein Stator (12) des DFIG mit einem mit dem Stator (12) des DFIG verbundenen AC Netz (70) synchronisiert wird.

5. Ein Verfahren nach einem der Ansprüche 1 bis 4, **dadurch gekennzeichnet, dass** die Statorspannung des DFIG (10) während des Betriebs des DFIG (10) innerhalb eines Nennspannungsbereichs der Statorspannung des DFIG liegt.

6. Ein Verfahren nach einem der Ansprüche 1 bis 4, **dadurch gekennzeichnet, dass** die Rotorspannung des DFIG mit einem an einen Rotor (11) des DFIG angeschlossenen Wechselrichter (30) gesteuert wird.

7. Ein Computer-Programmprodukt aufweisend Computer-Programmcode, **dadurch gekennzeichnet, dass** die Ausführung des Programmcodes in einem Computer dazu führt, dass der Computer die Schritte des Verfahrens nach einem der Ansprüche 1 bis 6 ausführt.

8. Eine Anordnung zur Bestimmung von Streuinduktivitäten eines doppelt gespeisten Asynchrongenerators, DFIG, wobei die Anordnung mindestens Eines von a) und b) umfasst:

   a) Mittel (30, 50), die dazu ausgeführt sind, während des Betriebs des DFIG (10) eine Rotorspannung des DFIG zu steuern, sodass ein Statorstrom des DFIG gegen Null geht;
   Mittel (50), die dazu ausgelegt sind, als Reaktion darauf, dass der Statorstrom des DFIG gleich oder kleiner als ein erster vorbestimmter Schwellwert ist, Werte einer Statorspannung des DFIG, einer Rotorspannung des DFIG und eines Rotorstroms des DFIG, oder Größen, die diese anzeigen, zu ermitteln; und
   Mittel (50), die dazu ausgelegt sind, eine Rotorstreuinduktivität des DFIG auf der Grundlage von zumindest den ermittelten Werten der Statorspannung des DFIG, der Rotorspannung des DFIG und des Rotorstroms des DFIG, oder den Größen, die diese anzeigen, zu berechnen,

b) Mittel (30, 50), die dazu ausgeführt sind, während des Betriebs des DFIG eine Rotorspannung des DFIG zu steuern, sodass der Rotorstrom des DFIG gegen Null geht;

Mittel (50), die dazu ausgelegt sind, als Reaktion darauf, dass der Rotorstrom des DFIG gleich oder kleiner als ein zweiter vorbestimmter Schwellwert ist, Werte der Statorspannung des DFIG, der Rotorspannung des DFIG und des Statorstroms des DFIG, oder Größen, die diese anzeigen, zu ermitteln; und

Mittel (50), die dazu ausgelegt sind, eine Statorstreuinduktivität des DFIG auf der Grundlage von zumindest den ermittelten Werten der Statorspannung des DFIG, der Rotorspannung des DFIG und des Statorstroms des DFIG, oder den Größen, die diese anzeigen, zu berechnen.

9. Eine Anordnung nach Anspruch 8, **dadurch gekennzeichnet, dass** für Alternative a) die zum Rechnen ausgeführten Mittel (50) dazu ausgeführt sind, die Rotorstreuinduktivität des DFIG (10) auf der Grundlage von den ermittelten Werten der Statorspannung des DFIG, der Rotorspannung des DFIG und des Rotorstroms des DFIG, oder den Größen, die diese anzeigen, und eines Rotorwiderstands des DFIG oder einer Größe, die diesen anzeigt, zu berechnen.

10. Eine Anordnung nach Anspruch 8 oder 9, **dadurch gekennzeichnet, dass** für Alternative b) die zum Rechnen ausgeführten Mittel (50) dazu ausgeführt sind, die Statorstreuinduktivität des DFIG (10) auf der Grundlage von den ermittelten Werten der Statorspannung des DFIG, der Rotorspannung des DFIG und des Statorstroms des DFIG, oder den Größen, die diese anzeigen, und eines Statorwiderstands des DFIG oder einer Größe, die diesen anzeigt, zu berechnen.

11. Eine Anordnung nach Anspruch 8, 9 oder 10, **dadurch gekennzeichnet, dass** während des Betriebs des DFIG (10) ein Stator (12) des DFIG mit einem mit dem Stator (12) des DFIG verbundenen AC Netz (70) synchronisiert wird.

12. Anordnung nach einem der Ansprüche 8 bis 11, **dadurch gekennzeichnet, dass** die Statorspannung des DFIG (10) während des Betriebs des DFIG innerhalb eines Nennspannungsbereichs der Statorspannung des DFIG liegt.

13. Ein Wechselrichter aufweisend eine Anordnung nach einem der Ansprüche 8 bis 12.

14. Ein Wechselrichter nach Anspruch 13, **dadurch gekennzeichnet, dass** der Wechselrichter (30) dazu ausgeführt ist, die ermittelte Rotorstreuinduktivität des DFIG und/oder die ermittelte Statorstreuinduktivität des DFIG zur Steuerung des DFIG zu verwenden.

15. Ein Frequenzumrichter aufweisend eine Anordnung nach einem der Ansprüche 8 bis 12.


**Revendications**

1. Procédé destiné à déterminer les inductances de fuite d'un générateur asynchrone à double alimentation, DFIG, le procédé comprenant les étapes consistant à :

au cours du fonctionnement du DFIG (10), exécuter l'une au moins des étapes a) et b) consistant à :

a) commander (120) la tension de rotor du DFIG de telle sorte que le courant de stator du DFIG approche zéro ;
en réponse au courant de stator du DFIG qui est (130) égal ou inférieur à un premier seuil prédéterminé, déterminer (140) les valeurs de la tension de stator du DFIG, de la tension de rotor du DFIG, et du courant de rotor du DFIG, ou des quantités indicatives de celles-ci ; et
calculer (140) une inductance de fuite de rotor du DFIG sur la base au moins des valeurs déterminées de la tension de stator du DFIG, de la tension de rotor du DFIG, et du courant de rotor du DFIG, ou des quantités indicatives de celles-ci ;
b) commander (150) la tension de rotor du DFIG de telle sorte que le courant de rotor du DFIG approche zéro ;

en réponse au courant de rotor du DFIG qui est (160) égal ou inférieur à un second seuil prédéterminé, déterminer (170) les valeurs de la tension de stator du DFIG, de la tension de rotor du DFIG, et du courant de stator du DFIG, ou des quantités indicatives de celles-ci ; et
calculer (170) une inductance de fuite de stator du DFIG sur la base au moins des valeurs déterminées de la tension de stator du DFIG, de la tension de rotor du DFIG, et du courant de stator du DFIG, ou des quantités indicatives de celles-ci.

2. Procédé selon la revendication 1, dans lequel, selon l'alternative a), l'inductance de fuite de rotor du DFIG (10) est calculée (140) sur la base des valeurs déterminées de la tension de stator du DFIG, de la tension de rotor du DFIG et du courant de rotor du DFIG, ou des quantités indicatives de celles-ci, et de la résistance de rotor du DFIG, ou d'une quantité indicative de celle-ci.

3. Procédé selon la revendication 1 ou la revendication 2, dans lequel, selon l'alternative b), l'inductance de fuite de stator du DFIG (10) est calculée (170) sur la base des valeurs déterminées de la tension de stator du DFIG, de la tension de rotor du DFIG et du courant de stator du DFIG, ou des quantités indicatives de celles-ci, et de la résistance de stator du DFIG, ou d'une quantité indicative de celle-ci.

4. Procédé selon l'une quelconque des revendications 1 à 3, dans lequel, au cours du fonctionnement du DFIG (10), le stator (12) du DFIG est synchronisé avec un réseau alternatif (70) connecté au stator (12) du DFIG.

5. Procédé selon l'une quelconque des revendications 1 à 4, dans lequel, au cours du fonctionnement du DFIG (10), la tension de stator du DFIG (10) se situe à l'intérieur d'une plage de tension nominale de la tension de stator du DFIG.

6. Procédé selon l'une quelconque des revendications 1 à 4, dans lequel la tension de rotor du DFIG est commandée par un onduleur (30) connecté au rotor (11) du DFIG.

7. Produit programme informatique qui comprend un code de programme informatique, dans lequel l'exécution du code de programme dans un ordinateur, fait exécuter par l'ordinateur les étapes du procédé selon l'une quelconque des revendications 1 à 6.

8. Agencement destiné à déterminer les inductances de fuite d'un générateur asynchrone à double alimentation, DFIG, l'agencement comprenant l'un au moins des éléments a) et b) :

   a) des moyens (30, 50) configurés, lors du fonctionnement du DFIG (10), de façon à commander la tension de rotor du DFIG de telle sorte que le courant de stator du DFIG approche zéro ;
   des moyens (50) configurés de façon à déterminer, en réponse au courant de stator du DFIG qui est égal ou inférieur à un premier seuil prédéterminé, les valeurs de la tension de stator du DFIG, de la tension de rotor du DFIG, et du courant de rotor du DFIG, ou des quantités indicatives de celles-ci ; et
   des moyens (50) configurés de façon à calculer une inductance de fuite de rotor du DFIG sur la base au moins des valeurs déterminées de la tension de stator du DFIG, de la tension de rotor du DFIG, et du courant de rotor du DFIG, ou des quantités indicatives de celles-ci ;
   b) des moyens (30, 50) configurés, lors du fonctionnement du DFIG, de façon à commander la tension de rotor du DFIG de telle sorte que le courant de rotor du DFIG approche zéro ;

   des moyens (50) configurés de façon à déterminer, en réponse au courant de rotor du DFIG qui est égal ou inférieur à un second seuil prédéterminé, les valeurs de la tension de stator du DFIG, de la tension de rotor du DFIG, et du courant de stator du DFIG, ou des quantités indicatives de celles-ci ; et
   des moyens (50) configurés de façon à calculer une inductance de fuite de stator du DFIG sur la base au moins des valeurs déterminées de la tension de stator du DFIG, de la tension de rotor du DFIG, et du courant de stator du DFIG, ou des quantités indicatives de celles-ci.

9. Agencement selon la revendication 8, dans lequel, selon l'alternative a), les moyens (50) configurés de façon à calculer, sont configurés de façon à calculer l'inductance de fuite de rotor du DFIG (10) sur la base des valeurs déterminées de la tension de stator du DFIG, de la tension de rotor du DFIG, et du courant de rotor du DFIG, ou des quantités indicatives de celles-ci, et de la résistance de rotor du DFIG, ou d'une quantité indicative de celle-ci.

10. Agencement selon la revendication 8 ou la revendication 9, dans lequel, selon l'alternative b), les moyens (50) configurés de façon à calculer, sont configurés de façon à calculer l'inductance de fuite de stator du DFIG (10) sur la base des valeurs déterminées de la tension de stator du DFIG, de la tension de rotor du DFIG, et du courant de stator du DFIG, ou des quantités indicatives de celles-ci, et de la résistance de stator du DFIG, ou d'une quantité indicative de celle-ci.

**11.** Agencement selon l'une quelconque des revendications 8 à 10, dans lequel, au cours du fonctionnement du DFIG (10), le stator (12) du DFIG est synchronisé avec un réseau alternatif (70) connecté au stator (12) du DFIG.

**12.** Agencement selon l'une quelconque des revendications 8 à 11, dans lequel, au cours du fonctionnement du DFIG, la tension de stator du DFIG (10) se situe à l'intérieur d'une plage de tension nominale de la tension de stator du DFIG.

**13.** Onduleur comprenant un agencement selon l'une quelconque des revendications 8 à 12.

**14.** Onduleur selon la revendication 13, dans lequel l'onduleur (30) est configuré de façon à utiliser l'inductance de fuite de rotor déterminée du DFIG, et / ou l'inductance de fuite de stator déterminée du DFIG, de manière à commander le DFIG.

**15.** Convertisseur de fréquence comprenant un agencement selon l'une quelconque des revendications 8 à 12.

Fig. 1

Fig. 2

$$\overline{I_s} \quad R_s \quad L_{ls} \qquad L_{lr}' \quad R_r' \quad \overline{I_r}'$$

$$\overline{U_s} \qquad L_m \quad \overline{U_{xm}} \qquad \overline{U_r}'$$

Fig. 3

54  53  52  51

0  $+$ $-$  |u|  Min tracking function  $I_{ref}$  $I_{act}$

Fig. 4

```
            ┌─────────────────────────┐
            │    Start identification  │───── 110
            └─────────────────────────┘
                         │
                         ▼ ◄──────────────────────┐
            ┌─────────────────────────────┐       │
            │ Control to get zero stator  │───── 120
            │          current            │       │
            └─────────────────────────────┘       │
                         │         130            │
                         ▼       ╱                 │
                      ╱─────────────╲      No      │
                     ╱  Is < min limit ╲──────────┘
                      ╲─────────────╱
                         │
                        Yes
                         ▼
            ┌─────────────────────────────┐
            │ Calculate rotor leakage     │───── 140
            │        inductance           │
            └─────────────────────────────┘
                         │
                         ▼ ◄──────────────────────┐
            ┌─────────────────────────────┐       │
            │ Control to get zero rotor   │───── 150
            │          current            │       │
            └─────────────────────────────┘       │
                         │         160            │
                         ▼       ╱                 │
                      ╱─────────────╲      No      │
                     ╱  Ir < min limit ╲──────────┘
                      ╲─────────────╱
                         │
                        Yes
                         ▼
            ┌─────────────────────────────┐
            │ Calculate stator leakage    │───── 170
            │        inductance           │
            └─────────────────────────────┘
                         │
                         ▼
            ┌─────────────────────────┐
            │   Identification done    │───── 180
            └─────────────────────────┘
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012104580 A